# EUROPEAN PATENT APPLICATION

(11) **EP 4 027 401 A1**
(43) Date of publication of application: **13.07.2022**
(21) Application number: 20861446.1
(22) Date of filing: 03.09.2020
(51) Int. Cl.: H01L 51/46, C01B 32/156

(54) **N-TYPE ORGANIC SEMICONDUCTOR LAYER, ORGANIC SEMICONDUCTOR DEVICE, AND N-TYPE DOPANT**

(30) Priority: 03.09.2019 JP 2019160022
(71) Applicant: Fukamatsugumi Co., Ltd., Aoba-ku Sendai-shi Miyagi 981-0931 (JP)
(72) Inventor: MATSUO, Yutaka, Tokyo 104-0051 (JP); UENO, Hiroshi, Sendai-shi, Miyagi 989-3201 (JP); JEON, Il, Tokyo 112-0002 (JP); OKADA, Hiroshi, Sendai-shi, Miyagi 981-0952 (JP)
(74) Representative: Dr. Weitzel & Partner
(86) International application number: PCT/JP2020/033404
(87) International publication number: WO 2021/045144

(57) **Abstract**

To provide an n-type dopant capable of providing high charge mobility and controlling the Fermi level. To provide an organic semiconductor layer having high charge mobility, no crystal distortion, no dopant diffusion even at high temperatures, and having a controlled Fermi level. To provide an organic semiconductor devices such as an organic semiconductor solar cells with high power conversion efficiency.

An n-type organic semiconductor layer, in which ionic atom encapsulated fullerene neutral substance is doped in a layer made of fullerene. The n-type semiconductor layer is an electron transport layer. N-type dopant including ionic atom encapsulated fullerene neutral substance doped in an organic semiconductor layer.

## Description

### TECHNICAL FIELD

The present invention relates to n-type organic semiconductor layer, organic semiconductor device, and n-type dopant.

### BACKGROUND ART

Organic electronics are technologically maturing and have multidisciplinary applicability. These devices are superior to those of inorganic substances in terms of process optimization in solution and possibility of improvement (Non-Patent Document 1). However, the low charge mobility of organic semiconductors is one of the major weaknesses (Non-Patent Document 2). In order to solve this problem, doping a small amount of charge carriers is widely used for improving charge mobility and adjusting the Fermi level (Non-Patent Document 3). However, the use of a metal as a dopant distorts the crystal structure of the organic semiconductor film itself, and there is a problem that the dopant is diffused at a high temperature (Non-Patent Document 4).

Therefore, there is a strong demand for the development of organic dopants that can provide high conductivity and control the Fermi level, which may lead to breakthroughs in organic semiconductors. In contrast to extensive research on doping of inorganic semiconductors, doping technology for organic semiconductors is still in its initial stage (Non-Patent Document 5). This is due to the inherently low activity of organic semiconductors with respect to the doping.

### PRIOR ART DOCUMENTS

### NON-PATENT DOCUMENTS

Non-Patent Document 1: (a) H. E. Katz,A. J. Lovinger, J. Johnson, C. Kloc, T. Siegrist, W. Li, Y. -Y. Lin, A. Dodabalapur,Nature, 2000, 404, 478; (b) I. D. W. Samuel, G. A. Turnbull, Chem.Rev., 2007, 107, 1272; (c) J. E. Anthony, Angew. Chem. Int. Ed.,2008, 47, 452.
Non-Patent Document 2: (a) V.Coropceanu, J. Cornil, D. A. da Silva Filho, Y. Olivier, R. Silbey, J.-L. Bredas,Chem. Rev., 2007, 107, 926; (b) V. Podzorov, E. Menard, A.Borissov, V. Kiryukhin, J. A. Rogers, M. E. Gershenson, Phys. Rev. Lett.,2004, 93, 086602.
Non-Patent Document 3: (a) Z. Wang, D. P. McMeekin, N. Sakai, S. van Reenen, K.Wojciechowski, J. B. Patel, M. B. Johnston, H. J. Snaith, Adv. Mater., 2017, 29,1604186; (b) K. H. Yim, G. L. Whiting, C. E. Murphy, J. J. M. Halls, J.H. Burroughes, R. H. Friend, J. S. Kim, Adv. Mater., 2008, 20,3319; (c) Q. Bao, X. Liu, S. Braun, Y. Li, J. Tang, C. Duan, M. Fahlman, ACSAppl. Mater. Interfaces, 2017, 9, 35476; (d) C. Kuang, G. Tang, T.Jiu, H. Yang, H. Liu, B. Li, W. Luo, X. Li, W. Zhang, F. Lu, J. Fang, Y Li, NanoLett., 2015, 15, 2756; (e) Z.-K Wang, L.-S. Liao, Adv. OpticalMater., 2018, 6, 1800276.
Non-Patent Document 4: (a) G.-H. Kim,L. Shao, K. Zhang, K. P. Pipe, Nature Mater., 2013, 12, 719; (b)B. Lussem, M. Riede,K. Leo, Phys. Status Solidi A, 2013, 210, 9.
Non-Patent Document 5: M. Hiramoto, M.Kikuchi, S. Izawa, Adv. Mater., 2019, 31, 1801236.
Non-Patent Document 6: H. Ueno, S. Aoyagi, YYamazaki, K. Ohkubo, N. Ikuma, H. Okada, T. Kato, Y Matsuo, S. Fukuzumi, K.Kokubo, Chem. Sci., 2016, 7, 5770.
Non-Patent Document 7: H. Okada, H. Ueno, Y Takabayashi,T. Nakagawa, M. Vrankic, J. Arvanitidis, T. Kusamoto, K. Prassides, Y Matsuo, Carbon,2019, 153, 467.
Non-Patent Document 8: R. S. Ruoff, D. S. Tse, R.Malhotra, D. C. Lorents, J. Phys. Chem., 1993, 97, 3379.
Non-Patent Document 9: (a) Y Matsuo, H. Okada,H. Ueno, Endohedral Lithium-Containing Fullerenes: Preparation,Derivatization, and Application, Springer, Singapore, 2017; (b) H. Okada,T. Komuro, T. Sakai, Y Matsuo, Y Ono, K. Omote, K. Yokoo, K. Kawachi, YKasama, S. Ono, R. Hatakeyama, T. Kaneko, H. Tobita, RSC Adv., 2012, 2,10624.
Non-Patent Document 10: H.-S. Lin, I. Jeon, R.Xiang, S. Seo, J.-W. Lee, C. Li, A. Pal, S. Manzhos, M. S. Goorsky, Y Yang, S.Maruyama, Y Matsuo, ACS Appl. Mater. Interfaces, 2018, 10,39590.
Non-Patent Document 11: I. Jeon, H. Ueno, S. Seo,K. Aitola, R. Nishikubo, A. Saeki, H. Okada, G. Boschloo, S. Maruyama, YMatsuo, Angew. Chem. Int. Ed., 2018, 57, 4607.

### DISCLOSURE OF THE INVENTION

### PROBLEMS TO BE SOLVED BY THE INVENTION

The use of a metal as a dopant distorts the crystal structure of the organic semiconductor film itself, and causes diffusion of the dopant at high temperatures (Non-Patent Document 4).

Therefore, there is a strong demand for the development of organic dopants that can provide high conductivity and control the Fermi level, which may lead to breakthrough in organic semiconductors. In contrast to extensive research on doping of inorganic semiconductors, doping technology for organic semiconductors is still in its initial stage (Non-Patent Document 5). This is due to the inherently low activity of organic semiconductors against doping.

An object of the present invention is to provide an n-type dopant capable of giving high charge mobility and controlling the Fermi level.

It is an object of the present invention to provide an organic semiconductor layer having high charge mobility, no crystal distortion, no dopant diffusion even at high temperatures, and having a controlled Fermi level.

An object of the present invention is to provide an organic semiconductor device such as an organic semiconductor solar cell having high power conversion efficiency.

### SOLUTION FOR SOLVE THE PROBLEMS

The invention according to claim 1 is an n-type organic semiconductor layer, in which ionic atom encapsulated fullerene neutral substance is doped in a layer made of fullerene.

The invention according to claim 2 is the n-type organic semiconductor layer according to claim 1, wherein an outer shell of the fullerene and an outer shell of the encapsulated fullerene are made of the same carbon.

The invention according to claim 3 is the n-type organic semiconductor layer according to claim 2, wherein the outer shell is C₆₀.

The invention according to claim 4 is the n-type semiconductor layer according to any one of claims 1 to 3, wherein the ionic atom is alkaline ionic atom.

The invention according to claim 5 is the n-type semiconductor layer according to claim 4, wherein the alkaline ionic atom is lithium ion.

The invention according to claim 6 is the n-type semiconductor layer according to any one of claims 1 to 5, wherein the amount of the doping is less than 1.5% by mass.

The invention according to claim 7 is an organic semiconductor device, in which the n-type semiconductor layer according to any one of claims 1 to 6 is an electron transport layer.

The invention according to claim 8 is the organic semiconductor device according to claim 7, wherein the organic semiconductor device is a perovskite solar cell.

The invention according to claim 9 is n-type dopant including ionic atom encapsulated fullerene neutral substance doped in the organic semiconductor layer.

### EFFECTS OF THE INVENTION

According to the present invention, the following various effects can be obtained.

According to the present invention, an n-type dopant, which gives high charge mobility to an organic semiconductor film and can control the Fermi level, can be obtained.

According to the present invention, it is possible to obtain an organic semiconductor layer having high charge mobility, no crystal distortion, no dopant diffusion even at high temperatures, and having a controlled Fermi level.

According to the present invention, an organic semiconductor device such as an organic semiconductor solar cell having high power conversion efficiency can be obtained.

### BRIEF DESCRIPTION OF THE DRAWINGS

FIG. 1 shows a diagram indicating a concept of doping, (a) shows the case where silicon is doped with P, and (b) shows the case where Li@C₆₀ is doped in C₆₀.
FIG. 2 shows graphs indicating particle size distributions, (a) shows particle size distribution of Pristine C₆₀ (0.1 mg/mL), (b) shows particle size distributions of Li@C₆₀ (B1 line: 0.1 mg/mL, B2 line: 0.2 mg/mL), and (c) shows particle size distributions of C₆₀ (0.1 mg/mL) with 0.5% (C1 line) or 1.0% (C2 line) Li@C₆₀ in o-DCB.
FIG. 3 relates to an embodiment, in which a solar cell is formed, (a) shows a layer structure, (b) shows energy state of each layer, (c) shows a graph indicating a relationship between amount of dopant and power conversion efficiency, (d) shows a graph indicating relationships between voltage bias and current density, and (e) shows relationships between wavelength and PL (photoluminescence) intensity in each layer.
FIG. 4 shows a conceptual diagram indicating a producing process of a dopant of the present invention.

### EMBODIMENT FOR CARRYING OUT THE INVENTION

In an n-type organic semiconductor layer of the present invention, ionic atom encapsulated fullerene neutral substance is doped in a layer made of fullerene.

The ionic atom encapsulated fullerene neutral substance is shown as "M⁺@Cₙ˙⁻". n is an integer of 60 or more. M⁺ is an ionic atom. The ionic atom M⁺ is contained inside the fullerene. Further, the fullerene has one electron in the shell portion, and the electron is expressed as "˙⁻". M⁺@C₆₀˙⁻ is neutral as a whole.

The M in M⁺ is, for example, an alkali metal or N.

Cₙ is, for example, C₆₀, C₇₀ or the like. C₆₀ is preferable because it has good symmetry and can be replaced stably and uniformly when doped. When the dope destination is C₆₀, it is preferable to use "M⁺@C_{60˙}⁻" having the same outer shell shape.

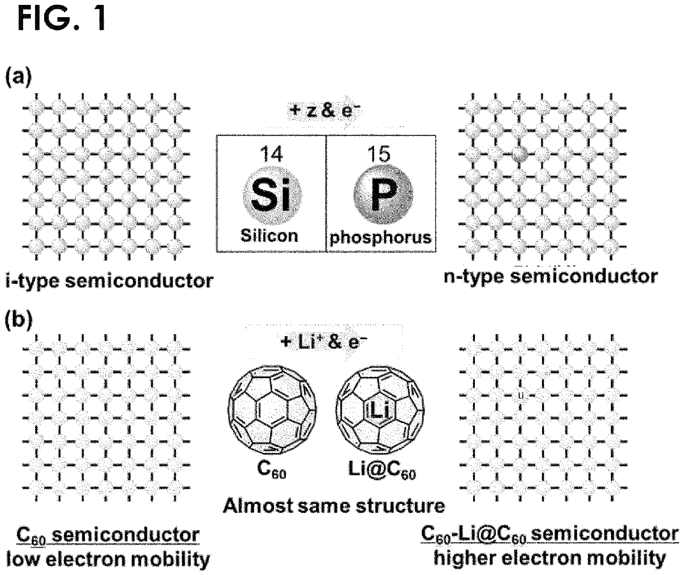

To explain again, Li⁺@C₆₀˙⁻(= Li@C₆₀) (Non-Patent Document 6) has almost the same molecular structure as fullerene C₆₀, and only the number of electrons is different. This means that a small number of Li@C₆₀ can be replaced in the solid C₆₀ without disturbing its structure. Due to these unique characteristics, the pair of Li@C₆₀ and C₆₀ can induce effective doping without the crystalline distortion typical of inorganic doping (FIG. 1). Furthermore, in this system, lithium ion is completely enclosed in fullerene, and deterioration due to ion diffusion is suppressed.

The actual electronic structure of the compound is Li⁺@C₆₀˙⁻, but in this specification, it may be referred to as Li@C₆₀ according to the custom of the contained fullerene research field.

In the organic semiconductor layer of the present invention, the Li@C₆₀ is used as the superatomic dopant of the original C₆₀. The obtained C₆₀:Li@C₆₀ hybrid material exhibits a Fermi level 0.12 eV higher than the original C₆₀, and the Li@C60 acts as an electron donor for the C₆₀.

Furthermore, an inverted type perovskite solar cell (PSC) was produced to show the device applicability of n-type semiconductor. The inverted type PSC with the C₆₀:Li@C₆₀ hybrid as an electron transport layer (ETL) showed 8.18% power conversion efficiency (PCE), which is higher than 4.67% of the PSC with the pure C₆₀ ETL. Such high performance is believed to be due to the improved conductivity of the ETL and the adjustment of the energy level.

Since the ETL is generally produced by a solution process, the solubility of the Li@C₆₀ in common organic solvents was screened and the results are summarized in Table 1. These compounds showed good solubility in orthodichlorobenzene (o-DCB) and carbon disulfide (CS2).

### EXAMPLES

### (Example 1)

In this example, an isolated dopant Li@C₆₀ was produced.

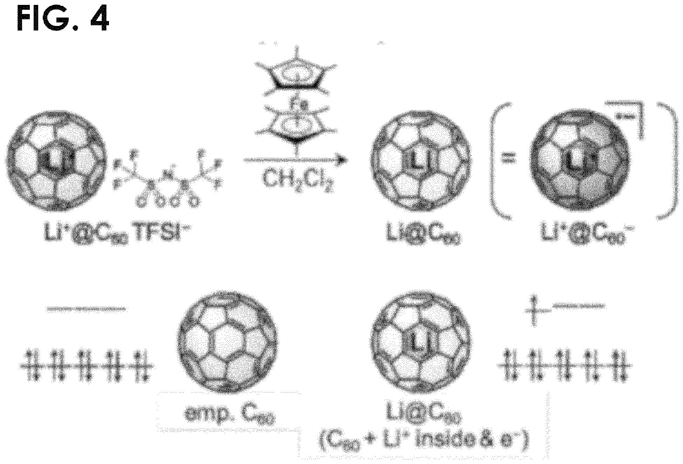

In this example, the dopant Li@C60 was synthesized according to the process shown in FIG. 4 (Non-Patent Document 7).

[Li+@C₆₀] PF6-salt from Idea International Incorporated Company was used as the starting material.

Anion exchange salt [Li+@C₆₀] TFSI-salt was prepared by the reported method. After sublimation purification, S1 decamethylferrocene was used as a reducing agent. Dichloromethane solution of decamethylferrocene (3.0 µmol/mL, 2.0 mL, 6.0 µmol) was slowly added to dichloromethane solution (2.5 mL) of [Li ⁺ @ C₆₀] TFSI- (5.0 mg, 5.0 µmol). After stirring for 15 minutes, a greenish-black dispersion liquid was obtained. The obtained solid was collected by filtration and washed 3 times with dichloromethane using an ultrasonic device. After filtration, the residue was dried under vacuum at ambient temperature and the Li@C₆₀ was isolated as black powder (2.9 mg, 4.0 µmol, 80%).

This isolated Li@C₆₀ can be used as a dopant.

### (Example 2)

In this example, an example, in which an n-type organic semiconductor film is formed as an electron transport layer (ETL) and changes in the Fermi level are measured, is shown.

In this example, o-DCB solution of the Li@C₆₀ prepared at 0 to 2 wt% was applied to an ITO substrate, and a C₆₀:Li@C₆₀ hybrid thin film was produced.

### It is described in detail below.

Since the ETL is generally produced by a solution process, the solubility of the Li@C₆₀ in common organic solvents was screened and the results are summarized in Table 1. It showed good solubility in orthodichlorobenzene (o-DCB) and carbon disulfide (CS2). Chlorobenzene, toluene, and dichloromethane are generally recognized as good solvents for the fullerenes, but in these solvents the Li@C₆₀ dimerized and the Li@C₆₀ did not dissolve. The o-DCB solution of the Li@C₆₀ prepared at 0 to 2 wt% was applied to the ITO substrate, and the C₆₀:Li@C₆₀ hybrid thin film was produced.

**(Table 1)**

| **solvent** | **Li@XC₆₀ solublity** | **emp. C₆₀ solubility⁸** |
|---|---|---|
| ***o*-DCB** | **1.1** | **27.0** |
| **Chlorobenzene** | **<0.1** | **7.0** |
| **CS₂** | **0.3** | **7.9** |
| **Toluene** | **insoluble** | **2.8** |
| **Dichloromethane** | **insoluble** | **0.26** |

It is described in more detail below.

The ITO glass substrate was washed and ultrasonically treated with a cleaning agent, distilled water, acetone, and isopropanol for 15 minutes in an ultrasonic bath. It was then placed in an ultraviolet / ozone (UV/O3) environment for 15 minutes. Subsequently, the Li@C₆₀ was added to the C₆₀ solution (20mg/mL) at 0 wt%, 0.5 wt%, 1.0 wt%, 1.5 wt%, and 2.0 wt% with respect to the C₆₀ to prepare an orthodichlorobenzene solution. And, they were spin-coated on an ozone-treated substrate at 3,000 rpm for 30 seconds. The Fermi level of the obtained thin film was measured using a Kelvin probe in a glove box filled with nitrogen (H₂O < 1 ppm, O₂ < 1 ppm). The results are shown in Table 2.

**(Table 2)**

| Li@C₆₀ conc. / wt% (mg/mL) | Fermi level (eV) |
|---|---|
| 0 (0) | -4.64±0.1 |
| 0.5 (0.1) | -4.51±0.1 |

The addition of the Li@C₆₀ increased the Fermi level of the C₆₀ thin film by about 0.12 eV, but a further increment of the Li@C₆₀ concentration did not further increase the Fermi level. In addition, the Fermi level values were uniform throughout the C₆₀:Li@C₆₀ hybrid film. These results mean that the Li@C₆₀ can effectively and uniformly execute n-type doping the original C₆₀ film. When the Li@C₆₀ was added in excess of 2%, the quality of the film was significantly reduced and the distribution of the Fermi levels became uneven. In fact, films with 1.5% or more the Li@C₆₀ added showed much lower performance in device experiments (It is clear from below).

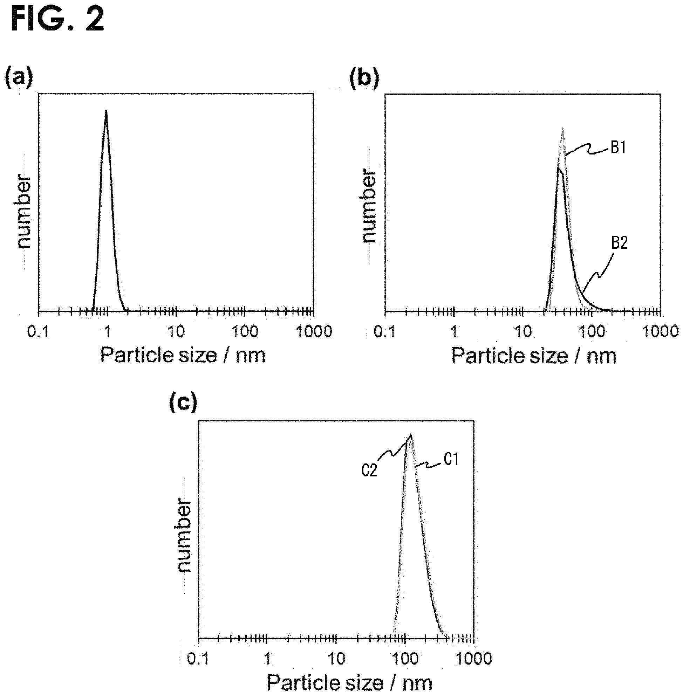

In order to elucidate the intramolecular interaction between the Li@C₆₀ and the empty C₆₀, particle size analysis of the C₆₀:Li@C₆₀ binary solution was performed by dynamic light scattering measurement. As shown in FIG. 2, the addition of the Li@C₆₀ induced aggregation of the C₆₀, and C₆₀:Li@C₆₀ nanoparticles at about 120 nm were formed. Based on the previously predicted intermolecular charge transfer interactions, it is speculated that they formed stable two-component nanoparticles. This was consistent with the behavior observed in the Fermi level measurement, where a non-uniform Fermi level distribution was observed at high dopant concentrations. When the Li@C₆₀ was further added, the particle size distribution became polydispersity and varied widely, and a large particle size exceeding 200 nm was also confirmed. This is consistent with the behavior, in which a non-uniform Fermi level distribution was observed at high dopant concentrations.

### (Example 3)

In this example, an organic semiconductor solar cell was produced.

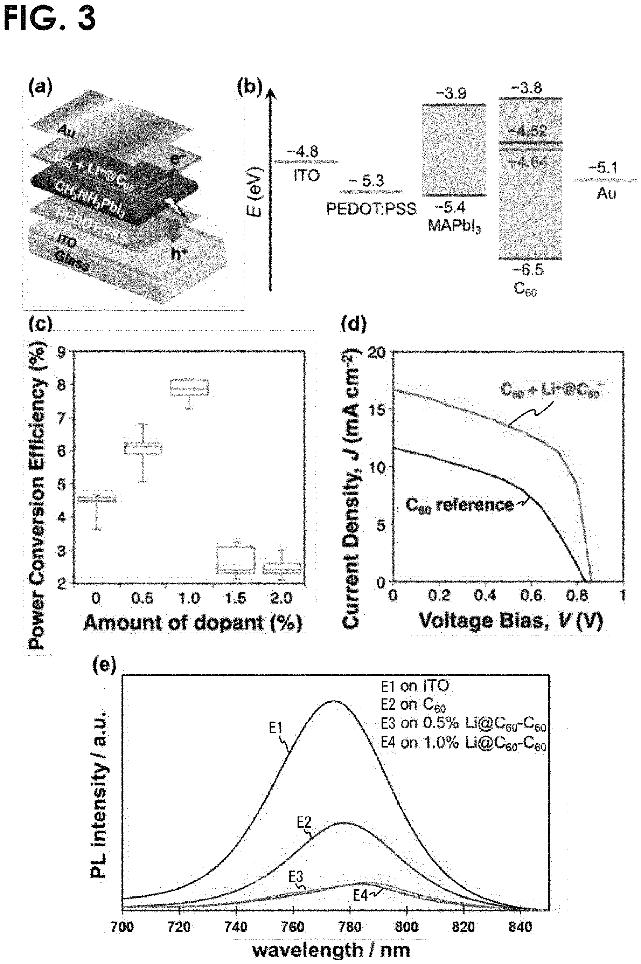

An inverted type PSC element was produced with a device configuration of glass / ITO / poly (3,4-ethylenedioxythiophene) polystyrene sulfonic acid (PEDOT:PSS) / CH₃NH₃PbI₃ / C₆₀:Li@C₆₀ / Au (FIG. 3(a), (b))

### (Non-Patent Document 10).

The production procedure is described in more detail.

An ITO pattern substrate (15 × 15 mm², sheet resistance 6 Ω/□) produced by Technoprint was ultrasonically washed with detergent, distilled water, acetone, and isopropyl alcohol for 15 minutes each. Next, UV-ozone treatment was performed for 15 minutes. Subsequently, 30 *µ* L of PEDOT:PSS was spin-coated at 3,000 rpm for 30 seconds and further heated at 105°C for 5 minutes. A perovskite precursor was prepared by dissolving CH₃NH₃I (TCI), PbI₂ (TCI) and dehydrated dimethyl sulfoxide (TCI) (molar ratio 1: 1: 1) in a dehydrated N, N-dimethylformamide solution to a weight ratio of 50 wt%. This solution was used after being filtered with a PTFE filter having a pore size of 0.45 µm. The 25 µL perovskite precursor solution was spin coated onto the PEDOT: PSS layer of the substrate described above at 4,000 rpm for 30 seconds. Ten seconds after the start of spin coating, 0.5 mL of dehydrated diethyl ether was slowly dropped. After that, it was heated at 100°C for 10 minutes. Next, to form the electron transport layer (ETL), orthodichlorobenzene solutions were prepared by adding Li@C₆₀ to C₆₀ fullerene solution (10 mg / mL) at 0 wt%, 0.5 wt%, 1.0 wt%, 1.5 wt%, and 2.0 wt%, respectively, with respect to C₆₀. And, these were spin-coated on respective substrates at 1,000 rpm for 30 seconds. Finally, as an electrode, gold with film thickness of 70 nm was prepared by heat vapor deposition (deposited film rate 0.05 nm/s) under vacuum.

A JV characteristics of a solar cell elements were measured by using a software-controlled source meter (Keithley 2400 Source-Meter) under a pseudo-solar light source (EMS-35AAA, Ushio Spax Inc. with UshioXe short arc lamp 500) in dark conditions and 1 sun (AM 1.5G; 100 mW cm⁻²). The source meter was calibrated using a silicon diode (BS-520BK, Bunkokeiki).

FIG. 3(c) shows a PCE (power conversion efficiency) of the inverted type PSC depending on the amount of Li@C60 dopant added. As the amount of dopant increases, PCE gradually increases, but decreases sharply from 1.5 wt%. The decrease in PCE at high dopant concentrations is associated with poor uniformity of membranes with high aggregation (Non-Patent Document 11). The optimum doping concentration was 1.0 wt%, the PCE was 8.18%, and the C60-based reference device showed a PCE of 4.67% (FIG. 3(d)).

The improvement in PCE came from improvements in all three photovoltaic parameters: short circuit current (JSC), open circuit voltage (VOC), and fill factor (FF). The addition of Li@C₆₀ increased conductivity and resulted in high FF, as evidenced by the decrease in series resistance (RS). The improved VOC is due to the better alignment of the Fermi level of the fullerene ETL with the conduction band of the perovskite layer. Furthermore, the degree of quenching of the perovskite layer confirmed by a photoluminescence (PL) spectrum showed that when Li@C₆₀ is added to the fullerene layer adjacent to the perovskite layer, the carrier extraction ability is far superior to that of the C₆₀-only layer (FIG. 3(e)).

In conclusion, we designed the concept of superatomic doping to increase electron transport capacity and thereby improved the performance of perovskite solar cells. The Li@C₆₀ dopant in the C₆₀ improved the energy level consistency with the conduction band of the perovskite layer and increased the electron mobility of the C₆₀ ETL. The optimized dopant conditions were 1.0% Li@C₆₀ in the concentration of 20 mg / mL C₆₀, the PSC showed PCE of 8.18%, and PCE 4.67% exceeded the reference device. In particular, all photovoltaic parameters, namely JSC, VOC, and FF, were significantly improved, and it is finally demonstrated that Li@C₆₀ can work as a superatomic dopant for C₆₀. Each characteristic is shown in Table 3.

The Li@C60 as a new type of dopant for the C₆₀ semiconductor films is presented by demonstrating its possibility in device applications using perovskite solar cells (PSC) as a platform. The C₆₀:Li@C₆₀ hybrid thin film exhibits a new "superatomic doping", which forms stable binary nanoparticles based on intermolecular charge transfer interactions. And, the thin film is uniformly doped as confirmed by dynamic light scattering experiments and Fermi level measurements. Li ions trapped in the fullerenes do not diffuse into the surround system and stably dope the C₆₀ film. Adjusting the energy level and improving electron mobility of the doped C₆₀ electron transport layer improves all photovoltaic parameters, namely JSC, VOC and FF, and ultimately improves PSC performance.

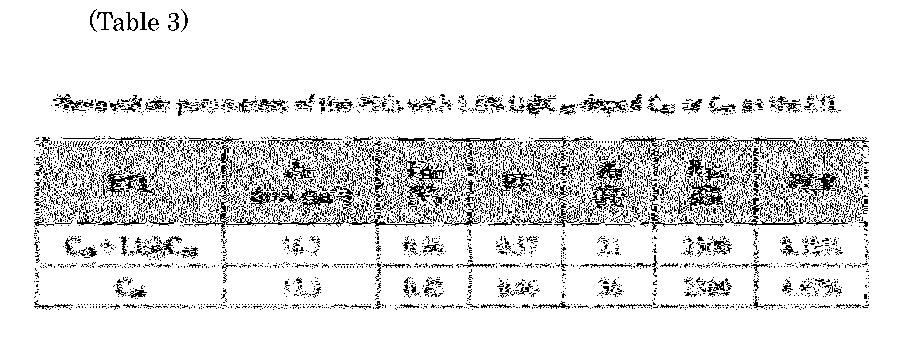

## Claims

1. An n-type organic semiconductor layer, in which ionic atom encapsulated fullerene neutral substance is doped in a layer made of fullerene.

2. The n-type organic semiconductor layer according to claim 1, wherein an outer shell of the fullerene and an outer shell of the encapsulated fullerene are made of the same carbon.

3. The n-type organic semiconductor layer according to claim 2, wherein the outer shell is C₆₀.

4. The n-type semiconductor layer according to any one of claims 1 to 3, wherein the ionic atom is alkaline ionic atom.

5. The n-type semiconductor layer according to claim 4, wherein the alkaline ionic atom is lithium ion.

6. The n-type semiconductor layer according to any one of claims 1 to 5, wherein the amount of the doping is less than 1.5% by mass.

7. An organic semiconductor device, in which the n-type semiconductor layer according to any one of claims 1 to 6 is an electron transport layer.

8. The organic semiconductor device according to claim 7, wherein the organic semiconductor device is a perovskite solar cell.

9. N-type dopant including ionic atom encapsulated fullerene neutral substance doped in the organic semiconductor layer.
